# EUROPÄISCHE PATENTSCHRIFT

(11) **EP 1 030 536 B1**
(45) Veröffentlichungstag und Bekanntmachung des Hinweises auf die Patenterteilung: **12.11.2003**
(21) Anmeldenummer: 00101346.5
(22) Anmeldetag: 24.01.2000
(51) Int. Cl.: H05B 3/74

(54) **Berührungsschalter für ein Elektro-Gerät**
Proximity commutator for housing electrical apparatuses
Commutateur de proximité destiné à un appareil électro-ménager

(30) Priorität: 19.02.1999 DE 19907226
(43) Veröffentlichungstag der Anmeldung: 23.08.2000
(73) Patentinhaber: E.G.O. ELEKTRO-GERÄTEBAU GmbH, 75038 Oberderdingen (DE)
(72) Erfinder: Schilling, Wilfried, D-76703 Kraichtal (DE)
(74) Vertreter: Patentanwälte Ruff, Wilhelm, Beier, Dauster & Partner

(56) Entgegenhaltungen:
- EP-A- 0 841 752
- EP-A- 0 859 468
- DE-A- 19 712 137
- DE-A- 19 802 479

## Beschreibung

### ANWENDUNGSGEBIET UND STAND DER TECHNIK

Die Erfindung betrifft einen Berührungsschalter für ein Elektro-Gerät, der ein Sensorelement mit einer Sensorfläche aus Flachmaterial aufweist, wobei er mit einer Ansteuerung für das Sensorelement verbunden ist und ihm eine Leuchtanzeige mit einem Gehäuse und darin angeordneten Leuchtmitteln zugeordnet ist.

Es sind Berührungsschalter mit rechteckigen metallischen Sensorflächen bekannt, beispielsweise Leiterbahnen oder -flächen auf keramischen Trägern, die federnd gelagert sein können. Derartige Berührungsschalter arbeiten auf kapazitiver Basis, das bedeutet, die Annäherung bzw. Berührung eines Fingers ruft eine Kapazitätsänderung des Sensorelements hervor, die detektiert werden kann. Sie können mittels Metallfedern o.dgl. an die Unterseite einer Abdeckung, beispielsweise einer Glaskeramikplatte eines Kochfeldes, angedrückt werden. Die Anordnung solcher federnder Sensorelemente, ihre Anpassung an eine Abdeckung sowie Montageprobleme erschweren die Anwendung.

DE-A-197 12 137 offenbart einen Berührungsschalter gemäß dem Oberbegriff des Patentanspruchs 1.

### AUFGABE UND LÖSUNG

Aufgabe der Erfindung ist es, einen Berührungsschalter zu schaffen, der die Nachteile des Standes der Technik überwindet, wobei er insbesondere bzgl. der Wirksamkeit sowie der Anwendungsvielfalt verbessert ist.

Diese Aufgabe wird dadurch gelöst, daß die Sensorfläche über dem Gehäuse verläuft und einen der Form der Leuchtmittel entsprechenden Ausschnitt aufweist, wobei sie im wesentlichen überdeckungsfrei die Leuchtmittel umgibt. Dies ermöglicht es, die Sensorfläche sozusagen zwischen Leuchtanzeige und Betätigungsfläche bzw. der Stelle einer Betätigung anzuordnen, ohne die Leuchtanzeige abzuschirmen.

Der Berührungsschalter bzw. das Sensorelement kann unter einer im wesentlichen geschlossenen Abdeckung angebracht sein, als besonders geeignet wird eine lichtdurchlässige Abdeckung angesehen, um die Leuchtmittel sichtbar zu machen. Eine Möglichkeit ist eine Glaskeramikplatte eines Elektro-Kochfeldes. Vorteilhaft liegt das Sensoelement mit der Sensorfläche an der Unterseite der Abdeckung an, insbesondere direkt an und mit einer gewissen Kraft angedrückt. Erfolgt die Betätigung des Berührungsschalters mittels kapazitiver Ankopplung eines Fingers an das Sensorelement durch die Abdeckung hindurch, so ist es von großem Vorteil, wenn die Distanz zwischen der Oberseite der Abdeckung und der Sensorfläche im wesentlichen immer gleich ist. Dies kann durch Andrücken erreicht werden.

Bevorzugt ist das Sensorelement im wesentlichen metallisch, beispielsweise kann es aus einem dünnen Metallblech bestehen. Insbesondere ist die Sensorfläche eben ausgebildet. Eine Möglichkeit zur Herstellung eines vorstehend beschriebenen Sensorelements ist es, dieses komplett und in einem einzigen Vorgang aus einer Fläche, insbesondere einem Metallblech, auszuarbeiten bzw. auszustanzen. Es kann mindestens einen Abschnitt aufweisen, mit dem es leitend und/oder befestigend mit einer Grundplatte, insbesondere einer Leiterplatte o. dgl., verbunden ist. Der Abschnitt ist vorteilhaft als Steckoder Standbein ausgebildet, wobei er durch Umbiegen aus dem Material des Sensorelements herausgearbeitet werden kann. Gemäß einer Ausführung kann ein Standbein starr ausgebildet sein. Gemäß einer besonders bevorzugten Ausführung, insbesondere bei einer einstückigen Herstellung, reichen die Standbeine nicht über die äußeren Begrenzungen der Grundfläche des Sensorelements über, bevorzugt verlaufen sie vor einem Umbiegen in einer inneren Fläche des Sensorelements.

Das Sensorelement kann die Leuchtmittel im wesentlichen umrahmen, vorzugsweise als geschlossener Rahmen. Je nach Art der Leuchtanzeige bzw. der beabsichtigen Betätigung des Berührungsschalters kann der Rahmen eine Breite im Bereich von 1 mm bis 5 mm aufweisen, insbesondere zwischen diesen Werten variierend mit sich verändernder Breite.

Gemäß einer bevorzugten Ausführung liegt das Sensorelement zumindest teilweise an dem Gehäuse der Leuchtanzeige an, insbesondere auf der einer Betätigung bzw. Abdeckung zugewandten Oberseite des Gehäuses. Dies ist besonders vorteilhaft bei Leuchtanzeigen mit einem Gehäuse, bei dem die Leuchtmittel einen deutlichen Abstand vom Rand nach innen einhalten. Dieser Abstand kann als Anlagefläche für das Sensorelement genutzt werden. Durch die Anlage ist vor allem eine mechanische Stabilisierung des Sensorelements möglich, ohne daß seine eigenen Standbeine diese Belastbarkeit erbringen können müssen.

Gemäß einer besonders bevorzugten Ausgestaltung der Erfindung kann die Sensorfläche eine zumindest teilweise flexible, elektrisch leitfähige Beschichtung aufweisen. Eine Abdeckung für den Berührungsschalter kann, insbesondere wenn es sich um eine Glaskeramikplatte handelt, an ihrer Unterseite eine unregelmäßige Oberfläche, insbesondere eine übliche Noppung, aufweisen. Starre Metallplatten liegen demzufolge lediglich an den Spitzen der höchsten Unregelmäßigkeiten auf. Es entsteht ein störender Luftspalt und die Distanz zwischen der Betätigungsfläche und der Sensorfläche ist bei einer Serienfertigung nicht konstant. Eine flexible, anpassungsfähige Beschichtung dagegen legt sich ideal an die unebene Unterseite einer Abdeckung an und vermeidet so die vorgenannten Probleme. Bevorzugt werden Kunststoff- oder Gummimaterialien, die durch Beimengung von Kohlenstoff, Ruß, Metall o. dgl. elektrisch leitfähig gemacht sind. In der Umgebung höherer Temperaturen können vorteilhaft Silikone verwendet werden. Die Dicke der Beschichtung kann, abhängig von der Anwendung und der üblichen Unebenheit, variieren. Als vorteilhaft wird eine Dicke im Bereich von 0,1 mm bis 2 mm angesehen, insbesondere von ca. 0,8 mm. Das flexible Material kann eine Härte im Bereich von 5 bis 20 Shore aufweisen. Als besonders bevorzugt werden ca. 10 bis 15 Shore angesehen.

Eine Möglichkeit ist es, die Beschichtung als Kontaktplatte aus elektrisch leitfähigem, flexiblem aufgeschäumtem Material auszubilden. Insbesondere kann sie aus einem großflächigen Bahnmaterial herausgearbeitet bzw. herausgestanzt und vorteilhaft nachträglich auf die Sensorfläche aufgebracht werden. Die Aufbringung bzw. Befestigung sollte einen elektrisch leitfähigen Übergang bilden, erreicht werden kann dies beispielsweise mittels eines leitfähigen Klebers oder eines entsprechenden Klebebandes. Eine Möglichkeit ist es, die Kontaktplatten nach Art von Aufklebern o. dgl. auf groBflächigen Bahnen bzw. langen Rollen mit einer gering haftenden Abdeckfolie für die Klebeschicht vorzusehen. Von diesem Vorrat kann jeweils eine Kontaktplatte abgezogen und auf eine Sensorfläche geklebt werden. Hierfür sind auch maschinelle bzw. automatische Verfahren bekannt und bevorzugt anzuwenden.

Die Beschichtung soll bevorzugt eine elektrisch leitfähige Anbindung an die Unterseite einer Abdeckung herstellen, deswegen wird sie elektrisch leitfähig gemacht. Der elektrische Widerstand der Beschichtung von Oberfläche zu Oberfläche kann in einem Bereich von wenigen Kiloohm bis 15 Kiloohm liegen, vorzugsweise beträgt er bei einer ca. 0,8 mm dicken Kontaktplatte ca. 7 Kiloohm. Für den Widerstand ist insbesondere zu beachten, daß der im Betrieb auf die Beschichtung ausgeübte Druck berücksichtigt wird.

Als Leuchtmittel werden solche mit einem im wesentlichen quaderförmiges Gehäuse mit ebener Oberseite bevorzugt, an bzw. unter der die Leuchtmittel angeordnet sind bzw. durch welche sie strahlen. Die Leuchtmittel sind vorteilhaft Leuchtdioden. Bei einer bevorzugten Ausführungsmöglichkeit ist die Leuchtanzeige eine numerische Anzeige, insbesondere eine Siebensegment-Anzeige, wobei die Segmente bevorzugt von Leuchtdioden gebildet werden. Eine weitere Möglichkeit sind LCD's, die aufgrund ihrer geringeren Lichtabstrahlung unter einer sehr lichtdurchlässigen bzw. durchsichtigen Abdeckung angeordnet sein sollten. Bei Verwendung hintergrundbeleuchteter LCD's sind auch dunkle Abdeckungen möglich.

Mit dem Sensorelement können Schaltmittel verbunden sein, beispielsweise Relais, die gemäß einer Betätigung der Sensorfläche ein an dem Sensorelement erzeugtes Schaltsignal in umgesetzter Form zugeführt bekommen und eine elektrische Leistung schalten. Auf diese Weise wird am Sensorelement lediglich mit Signalpegeln gearbeitet, während größere Leistungen separat mit üblichen Schaltern mit elektrischen Kontakten o.dgl. geschaltet werden können.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### KURZBESCHREIBUNG DER ZEICHNUNGEN

Ein Ausführungsbeispiel der Erfindung ist in den Zeichnungen dargestellt und wird im folgenden näher erläutert. In den Zeichnungen zeigen:
- Fig. 1: eine Seitenansicht eines auf dem Gehäuse einer Anzeige ruhenden Sensorelements, das mit einer flexiblen Kontaktplatte gegen die Unterseite einer Abdeckung gedrückt ist,
- Fig. 2: eine Draufsicht auf die Anordnung aus Fig. 1 die zeigt, wie das Sensorelement samt Beschichtung die numerische Anzeige umrahmt und dementsprechend ausgeschnitten ist sowie
- Fig. 3: eine Draufsicht auf ein Sensorelement nach dem Austanzen aus Metallblech.

### DETAILLIERTE BESCHREIBUNG DES AUSFÜHRUNGSBEISPIELS

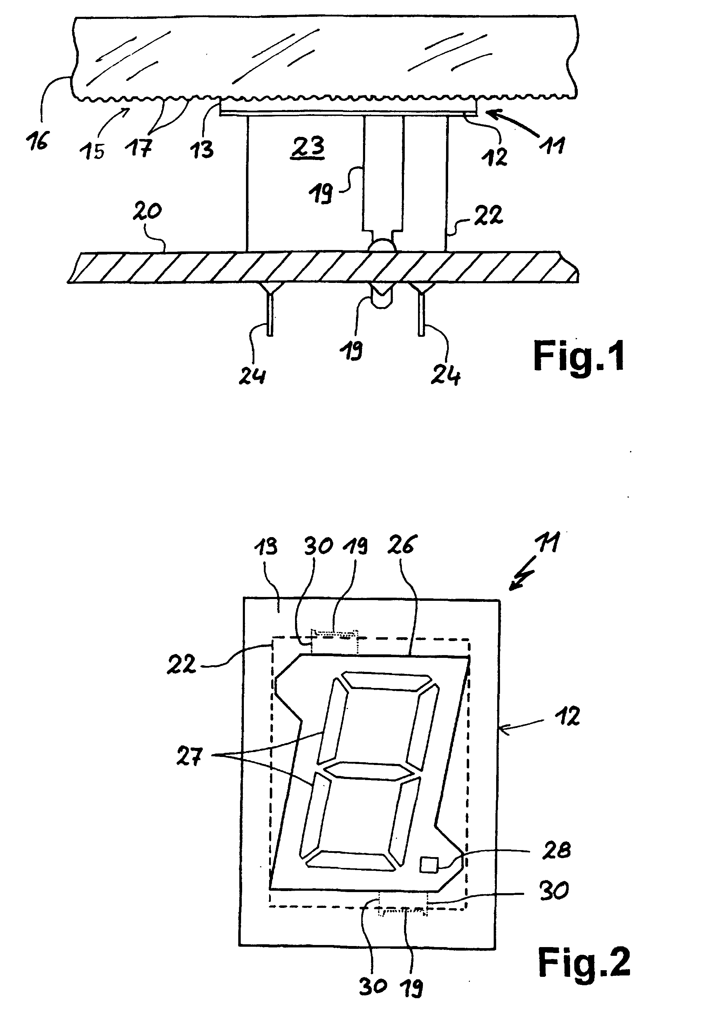

In der Fig. 1 ist ein Sensorelement 11 in Seitenansicht dargestellt, das eine Sensorfläche 12 aufweist, welche eine flexible Kontaktplatte 13 nach Art einer Beschichtung trägt. Mit der elastischen Kontaktplatte 13 ist das Sensorelement 11 gegen die Unterseite 15 einer Glaskeramikplatte 16 gedrückt. Die Unterseite 15 weist mehr oder weniger regelemäßig Noppen 17 auf, die jedoch problemlos in die Kontaktplatte 13 eingedrückt werden. Dadurch kann diese flächig und im wesentlichen ohne Luftspalt an der Unterseite 15 anliegen. In der Fig. 1 wurde die Dicke der Kontaktplatte 13 so gewählt, daß die Eindringtiefe der Noppen 17 ca. 20 % der Dicke entspricht.

Mittels zweier Standbeine 19, die von der Sensorfläche 12 abgehen und von denen nur das vordere in der Fig. 1 zu sehen ist, ist das Sensorelement 11 an einer Leiterplatte 20 angelötet. Elektrische Kontaktierungen sowie Leiterbahnen sind hier der Übersichtlichkeit halber weggelassen. Selbstverständlich kann die Leiterplatte 20 jedoch sowohl diese als auch darüber hinausgehend weitere elektrische und/oder elektronische Bauteile tragen.

Unter dem Sensorelement 11 ist das Gehäuse 22 einer Siebensegment-Anzeige 23 angeordnet und mit Lötpins 24 an der Leiterplatte 20 verlötet. Wie zu erkennen ist, liegt das Sensorelement 11 bzw. die Sensorfläche 12 auf der Siebensegment-Anzeige 23 auf, wird also durch diese unterstützt. Aufgrund der robusten Ausführung von Gehäusen solcher Siebensegment-Anzeigen 23 kann eine Anordnung gemäß Fig. 1 vorteilhaft die Aufgabe von Distanzhaltern zwischen einer Leiterplatte 20 und einer Abdeckung 16 übernehmen. Die Standbeine 19 haben im wesentlichen die Aufgabe der elektrischen Kontaktierung sowie die, das Sensorelement 11 nach unten gegen die Anzeige 23 zu drücken.

Die Draufsicht in der Fig. 2 zeigt die rahmenförmige Ausbildung des Sensorelements 11 mit dem Ausschnitt 26, der im wesentlichen kongruent sowohl in der Kontaktplatte 13 als auch in der Sensorfläche 12 ausgebildet ist. Die in Fig. 2 dargestellte spezielle Ausbildung des Ausschnitts 26 ist dem äußeren Verlauf der Segmentbalken 27 sowie des Leuchtpunktes 28 der Anzeige 23 nachgebildet. Die Sensorfläche 12 liegt überall auf dem gestrichelt dargestellten Gehäuse 22 der Anzeige 23 auf. Darüber hinaus überragt sie dessen Seiten jeweils um ein gewisses Stück mit den Außenabmessungen eines Rechtecks. Gepunktet dargestellt sind Einschnitte 30 in die Sensorfläche 12, an denen die Standbeine 19 in die Zeichenebene hinein abgebogen sind. Der Ausschnitt kann individuell an die Anordnung der Segmentbalken angepaßt werden.

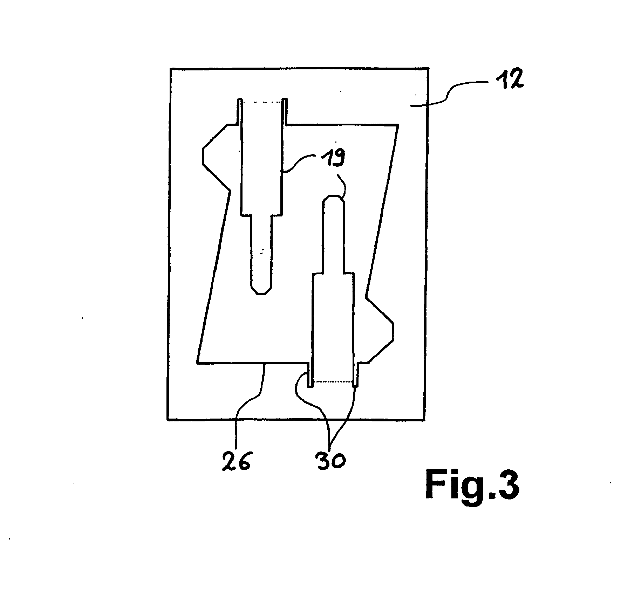

Fig. 3 zeigt eine Draufsicht auf eine Sensorfläche 12, aus der der Ausschnitt 26 sowie die Einschnitte 30 ausgestanzt bzw. herausgearbeitet worden sind. Zu erkennen ist die vorteilhafte Anordnung der nicht umgebogenen Standbeine 19 innerhalb des Ausschnittes 26, wodurch sich die zur Herstellung einer Sensorfläche 12 benötigte Materialfläche reduzieren läßt. Die diametral gegenüberliegend angeordneten Standbeine 19 bieten eine gute und ausreichende Befestigung des Sensorelements 11 nach unten gegen das Gehäuse 22 der Anzeige 23. Es ist zu erkennen, daß die Standbeine 19 knapp am Gehäuse 22 der Anzeige 23 vorbeilaufen. Dies kann unter. anderem vorteilhaft für eine Positionierung des Sensorelements 11 beim Einsetzen in die Leiterplatte 20 sein.

Nach dem Stanzvorgang kann eine Kontaktplatte 13, beispielsweise in der Ausbildung nach Fig. 2, auf die Sensorfläche 12 bzw. die Oberseite des Sensorelements 11 geklebt werden. Erst danach werden die Standbeine 19 entlang der punktierten Linien umgebogen.

Einer der großen Vorteile der Erfindung ist es, eine berührungssensitive Anzeige zu schaffen. Der Benutzer muß nicht getrennt von der Anzeige angeordnete Sensorflächen auszulösen, die möglicherweise erst gesucht bzw. zugeordnet werden müssen. Ein Auflegen des Fingers auf die deutlich sichtbare Leuchtanzeige bzw. die darüber verlaufende Abdeckung ist zur Auslösung eines Schaltvorgangs ausreichend, beispielsweise als Ein/Aus-Schalter einer Kochfeldsteuerung. Die Größe üblicher Siebensegment-Anzeigen 23 bzw. der enthaltenen Segmentbalken 27 ermöglicht eine als ausreichend anzusehene Dimensionierung der Betätigungsfläche des Sensorelements 11. Eine Form üblicherweise verwendeter Anzeigen dieser Art weist ein Gehäuse mit Abmessungen von ca. 9.5 mm auf 13 mm auf.

Ein weiterer großer Vorteil liegt in der flexiblen Beschichtung des Sensorelements 11, durch die eine bis dato bei metallischen Sensorflächen 12 noch nicht zu erreichende genaue Anpassung an die Unterseite einer genoppten Glaskeramikplatte 16 möglich wird. Weitere Eigenschaften des flexiblen Materials, wie sein innerer elektrischer sowie sein induktiver Widerstand aufgrund der Leitfähigkeit und des Volumens, wirken sich vorteilhaft auf die Auswertung einer Betätigung aus bzw. können zur Unterdrückung von Störsignalen beitragen.

Eine Ansteuerung des Sensorelements kann über verschiedene bekannte Verfahren bzw. Ansteuerungen erfolgen. Als besonders vorteilhaft wird eine Schaltungsanordnung angesehen, die in der DE 297 21 213 enthalten ist.

## Patentansprüche

1. Berührungsschalter für ein Elektro-Gerät, der ein Sensorelement mit einer Sensorfläche aus Flachmaterial aufweist, wobei er mit einer Ansteuerung für das Sensorelement verbunden ist und ihm eine Leuchtanzeige mit einem Gehäuse und darin angeordneten Leuchtmitteln zugeordnet ist, **dadurch gekennzeichnet, daß** die Sensorfläche (12) über dem Gehäuse (22) verläuft und einen der Form der Leuchtmittel (27, 28) entsprechenden Ausschnitt (26) aufweist, wobei sie im wesentlichen überdeckungsfrei die Leuchtmittel (27, 28) umgibt.

2. Berührungsschalter nach Anspruch 1, **dadurch gekennzeichnet, daß** das Sensorelement (11) unter einer Abdeckung angebracht ist, insbesondere einer lichtdurchlässigen Abdeckung, wobei die Abdeckung vorzugsweise eine Glaskeramikplatte (16) eines Elektro-Kochfeldes ist und/oder das Sensorelement (11) mit der Sensorfläche (12) an der Unterseite (15) der Abdeckung (16) anliegt, insbesondere angedrückt anliegt.

3. Berührungsschalter nach wenigstens einem der vorhergehenden Ansprüche, **dadurch gekennzeichnet, daß** das Sensorelement (11) im wesentlichen aus Metallblech besteht.

4. Berührungsschalter nach wenigstens einem der vorhergehenden Ansprüche, **dadurch gekennzeichnet, daß** das Sensorelement (11) wenigstens einen als Standbein (19) ausgebildeten Abschnitt aufweist, der insbesondere starr ausgebildet ist, wobei dieser vorzugsweise aus der Grundfläche, insbesondere einer inneren Fläche (26), der Sensorfläche (12) ausgestanzt und/oder abgebogen ist.

5. Berührungsschalter nach wenigstens einem der vorhergehenden Ansprüche, **dadurch gekennzeichnet, daß** das Sensorelement (11) die Leuchtmittel (27, 28) im wesentlichen umrahmend ausgebildet ist, wobei es vorzugsweise nach Art eines umlaufenden Rahmens ausgebildet ist, insbesondere mit einer Breite im Bereich von 1 mm bis 4 mm.

6. Berührungsschalter nach wenigstens einem der vorhergehenden Ansprüche, **dadurch gekennzeichnet, daß** das Sensorelement (11) zumindest teilweise am Gehäuse (22) anliegt, insbesondere an der einer Abdeckung (16) und/oder Betätigung zugewandten Oberseite des Gehäuses, wobei es vorzugsweise am Randbereich des Gehäuses anliegt.

7. Berührungsschalter nach wenigstens einem der vorhergehenden Ansprüche, **dadurch gekennzeichnet, daß** die Sensorfläche (12) eine zumindest teilweise flexible, elektrisch leitfähige Beschichtung (13) aufweist, insbesondere aus Kunststoff- oder Gummimaterial, wobei sie vorzugsweise eine Dicke im Bereich von 0,1 mm bis 2 mm aufweist, insbesondere von ca. 0,8 mm, daß die Beschichtung eine Kontaktplatte (13) aus elektrisch leitfähigem Schaumstoff ist, die insbesondere aus einem Bahnmaterial herausgearbeitet ist, wobei sie vorzugsweise auf die Sensorfläche (12) aufbringbar ist, daß der elektrische Widerstand der Beschichtung (13) von Oberfläche zu Oberfläche im Bereich von 1 Kiloohm bis 15 Kiloohm liegt, vorzugsweise bei ca. 7 Kiloohm und/oder die flexible Beschichtung (13) eine Härte im Bereich von 5 bis 20 Shore aufweist, vorzugsweise von 10 bis 15 Shore.

8. Berührungsschalter nach wenigstens einem der vorhergehenden Ansprüche, **dadurch gekennzeichnet, daß** die Leuchtanzeige (23) ein im wesentlichen quaderförmiges Gehäuse (22) mit einer ebenen Oberseite aufweist, an der die Leuchtmittel (27, 28) angeordnet sind.

9. Berührungsschalter nach wenigstens einem der vorhergehenden Ansprüche, **dadurch gekennzeichnet, daß** die Leuchtanzeige (23) eine numerische Anzeige ist, insbesondere Leuchtdioden (27, 28) aufweist, wobei sie vorzugsweise eine Siebensegment-Anzeige ist.

10. Berührungsschalter nach wenigstens einem der vorhergehenden Ansprüche, **dadurch gekennzeichnet, daß** die Ansteuerung des Sensorelements (11) mit Schaltmitteln zum Schalten einer elektrischen Leistung gemäß dem durch Einwirkung auf die Sensorfläche (12) erzeugten Schaltsignal versehen ist.

## Claims

1. Contact switch for an electrical appliance having a sensor element with a flat material sensor surface and which is connected to a control for the sensor element and with it is associated an illuminated display with a housing and lighting means located therein, **characterized in that** the sensor surface (12) passes over the housing (22) and has a cutout (26) corresponding to the shape of the lighting means (27, 28) and surrounds said lighting means (27, 28) in a substantially overlap-free manner.

2. Contact switch according to claim 1, **characterized in that** the sensor element (11) is fitted under a cover, particularly a translucent cover, which is preferably a glass ceramic plate (16) of an electric cooking area and/or the sensor element (11) engages with the sensor surface (12) on the underside (15) of the cover (16) and is in particular pressed thereon.

3. Contact switch according to at least one of the preceding claims, **characterized in that** the sensor element (11) is essentially formed from sheet metal.

4. Contact switch according to at least one of the preceding claims, **characterized in that** the sensor element (11) has at least one portion constructed as a standing leg (19), which in particular has a rigid construction and is preferably punched and/or bent from the base face, particularly an inner face (26) of the sensor surface (12).

5. Contact switch according to at least one of the preceding claims, **characterized in that** the sensor element (11) is constructed so as to substantially frame the lighting means (27, 28) and is preferably constructed in the manner of an all-round frame, particularly with a width of 1 to 4 mm.

6. Contact switch according to at least one of the preceding claims, **characterized in that** the sensor element (11) at least partly engages on the housing (22), particularly on the top of the housing facing a cover (16) and/or actuating means and preferably engages on the marginal area of the housing.

7. Contact switch according to at least one of the preceding claims, **characterized in that** the sensor surface (12) has an at least partly flexible, electrically conductive coating (13), particularly of plastic or rubber material and it preferably has a thickness between 0.1 and 2 mm and in particular of approximately 0.8 mm, that the coating is a contact plate (13) of electrically conductive foam, which is in particular worked from a web material and is preferably applied to the sensor surface (12), that the electrical resistance of the coating (13) from surface to surface is in the range of 1 to 15 kiloohm, preferably approximately 7 kiloohm and/or that the flexible coating (13) has a Shore hardness in the range 5 to 20 and preferably 10 to 15.

8. Contact switch according to at least one of the preceding claims, **characterized in that** the illuminated display (23) has a substantially parallelepipedic housing (22) with a planar top surface on which are located the lighting means (27, 28).

9. Contact switch according to at least one of the preceding claims, **characterized in that** the illuminated display (23) is a digital display, particularly having light emitting diodes (27, 28) and is preferably a seven-segment display.

10. Contact switch according to at least one of the preceding claims, **characterized in that** the sensor element (11) is controlled with switching means for switching an electrical power in accordance with the switching signal produced by action on the sensor surface (12).

## Revendications

1. Commutateur de proximité destiné à une appareil électroménager, qui présente un élément capteur avec une surface détectrice en matériau plat, et qui est relié à un dispositif d'excitation pour l'élément capteur et à qui est affecté un affichage lumineux avec un boîtier dans lequel sont placées des sources lumineuses, **caractérisé en ce que** la surface détectrice (12) s'étend sur le boîtier (22) et présente une découpe (26) correspondant à la forme des sources lumineuses (27, 28), et entoure les sources lumineuses (27, 28) sans les recouvrir pour l'essentiel.

2. Commutateur de proximité selon la revendication 1, **caractérisé en ce que** l'élément capteur (11) est placé sous un recouvrement, en particulier un recouvrement transparent, le recouvrement étant de préférence une plaque en vitrocéramique (16) d'une plaque de cuisson électrique, et/ou l'élément capteur (11) avec la surface détectrice (12) s'appuie, en particulier en étant pressé, sur la face inférieure (15) du recouvrement (16).

3. Commutateur de proximité selon au moins l'une des revendications précédentes, **caractérisé en ce que** l'élément capteur (11) est pour l'essentiel constituée de tôle métallique.

4. Commutateur de proximité selon au moins l'une des revendications précédentes, **caractérisé en ce que** l'élément capteur (11) présente au moins une section formée comme jambe de soutien (19), en particulier formée de manière rigide, cette dernière étant de préférence découpée à la matrice et/ou pliée à partir de la surface de base, en particulier d'une surface intérieure (26) de la surface détectrice (12).

5. Commutateur de proximité selon au moins l'une des revendications précédentes, **caractérisé en ce que** l'élément capteur (11) est formé de manière à encadrer pour l'essentiel les sources lumineuses (27, 28), en étant de préférence formé à la manière d'un cadre périphérique, en particulier avec une largeur se situant entre 1 mm à 4 mm.

6. Commutateur de proximité selon au moins l'une des revendications précédentes, **caractérisé en ce que** l'élément capteur (11) s'appuie au moins en partie sur le boîtier (22), en particulier sur la face supérieure du boîtier tournée vers un recouvrement (16) et/ou une commande, et s'appuie de préférence sur les bords du boîtier.

7. Commutateur de proximité selon au moins l'une des revendications précédentes, **caractérisé en ce que** la surface détectrice (12) présente un revêtement (13) au moins en partie flexible et conduisant l'électricité, en particulier en matière plastique ou caoutchouteuse, présentant de préférence une épaisseur se situant entre 0,1 mm et 2 mm, en particulier à environ 0,8 mm, **en ce que** le revêtement est une plaque de contact (13) en produit alvéolaire conduisant l'électricité, en particulier façonnée à partir d'un matériau en panneau, pouvant être de préférence appliquée sur la surface détectrice (12), **en ce que** la résistance électrique du revêtement (13) d'une surface à l'autre se situe entre 1 kilo-ohm et 15 kilo-ohms, de préférence à environ 7 kilo-ohms, et/ou le revêtement flexible (13) présente une dureté se situant entre 5 et 20 Shore, de préférence entre 10 et 15 Shore.

8. Commutateur de proximité selon au moins l'une des revendications précédentes, **caractérisé en ce que** l'affichage lumineux (23) présente un boîtier (22) de forme essentiellement parallélépipédique avec une face supérieure plane sur laquelle sont placées les sources lumineuses (27, 28).

9. Commutateur de proximité selon au moins l'une des revendications précédentes, **caractérisé en ce que** l'affichage lumineux (23) est un affichage numérique, présente en particulier des diodes électroluminescentes (27, 28), et est de préférence un affichage à sept segments.

10. Commutateur de proximité selon au moins l'une des revendications précédentes, **caractérisé en ce que** le dispositif d'excitation de l'élément capteur (11) est muni de dispositifs de commutation pour générer une puissance électrique conformément au signal de commutation émis par effet sur la surface détectrice (12).
